# EUROPÄISCHE PATENTANMELDUNG

(11) **EP 1 473 382 A1**
(43) Veröffentlichungstag der Anmeldung: **03.11.2004**
(21) Anmeldenummer: 03028073.9
(22) Anmeldetag: 09.12.2003
(51) Int. Cl.: C23C 14/35, H01J 37/34

(54) **Verfahren und Einrichtung zur plasmaaktivierten Schichtabscheidung durch Kathodenzerstäubung nach dem Magnetron-Prinzip**

(30) Priorität: 29.01.2003 DE 10303428
(71) Anmelder: Fraunhofer-Gesellschaft zur Förderung der angewandten Forschung e.V., 80686 München (DE)
(72) Erfinder: Fietzke, Fred, Dr., 01728 Hänichen (DE); Goedicke, Klaus, 01307 Dresden (DE); Wünsche, Tilo, Dr., 01127 Dresden (DE); Klostermann, Heidrun, Dr., 01326 Dresden (DE); Liebig, Jörn-Steffen, 01328 Dresden OT Malschendorf (DE)

(57) **Zusammenfassung**

Die Erfindung betrifft ein Verfahren und eine Einrichtung zur plasmaaktivierten Schichtabscheidung durch Kathodenzerstäubung nach dem Magnetron-Prinzip, bei dem während der Beschichtung mehrmals eine gezielte Reduzierung des Absolutbetrages der magnetischen Feldstärke des Magnetron-Magnetfeldes auf einen solchen Wert vorgenommen wird, der eine Verringerung des Entladungsstromes der Magnetronentladung um mindestens 20 % bewirkt.

## Beschreibung

Die Erfindung betrifft ein Verfahren und eine zu seiner Durchführung geeignete Einrichtung zur plasmaaktivierten Abscheidung hochwertiger dünner Schichten auf Substraten durch Kathodenzerstäubung nach dem Magnetron-Prinzip. Insbesondere sollen derartige Schichten ein dichtes porenfreies Gefüge aufweisen, sich durch eine hohe Haftung auf dem Substrat auszeichnen und häufig - beispielsweise im Falle einer reaktiven Schichtabscheidung - eine stöchiometrische Zusammensetzung besitzen. Physikalisch betrachtet betrifft die Erfindung eine Einrichtung zum plasmaaktivierten Magnetron-Sputtern.
Das Magnetron-Sputtern gehört zu den am weitesten verbreiteten Verfahren der Vakuumbeschichtung, um dünne Schichten aus Metallen, Legierungen und chemischen Verbindungen abzuscheiden. Im Falle der Zerstäubung elektrisch leitender Materialien wird dazu eine Gleichstromentladung erzeugt, für isolierende Materialien wird durch RF-Entladungen, z. B. mit 13,56 MHz, das Zerstäuben des Materials, das in Form eines sog. Targets vorliegt, erreicht. Besonders hohe Abscheideraten für die Beschichtung von Substraten mit chemischen Verbindungen werden durch reaktives Sputtern eines elektrisch leitfähigen Targets in einem Inertgas-Reaktivgas-Gemisch erreicht. Um auch elektrisch nichtleitende Materialien mit hoher Abscheiderate auf Substrate aufzubringen, wurde das reaktive Sputtern mit mittelfrequent gepulsten Entladungen in die Beschichtungstechnik eingeführt. [S. Schiller, K. Goedicke, J. Reschke, V. Kirchhoff, S. Schneider, F. Milde: Pulsed magnetron sputter technology, Surf. Coat. Technol. 61 (1993) 331-337].

In der Vakuumbeschichtungstechnik ist die Aktivierung des Abscheideprozesses durch Ionen und/oder durch andere energiereiche Spezies eines Plasmas seit langem bekannt. [G. Kienel (Hsg.): Vakuumbeschichtung, Bd. 2 - Verfahren und Anlagen, VDI Verlag 1995]. Eine Vorspannung am Substrat, wie z. B. in DE 44 12 906 C1 beschrieben, ermöglicht darüber hinaus die Erhöhung der Energie von Ionen, die während des Kondensationsprozesses auf das Substrat treffen. Auf diese Weise werden je nach Anteil und Energie der Spezies des Plasmas unterschiedliche Elementarwirkungen auf der Substratoberfläche erreicht, z. B. Desorption von Fremdatomen, locker gebundenen Atomen oder Molekülen, erhöhte laterale Beweglichkeit der kondensierenden Partikel, Implantation energetisch aktivierter Teilchen und weitere Effekte. Als Konsequenz ergibt sich eine weitreichende Möglichkeit zur gezielten Beeinflussung der Struktur und der physikalisch-chemischen Eigenschaften der abgeschiedenen dünnen Schicht.

Es gibt Vakuumbeschichtungsverfahren wie z. B. das Vakuumbogenverdampfen (arc evaporation) oder das Laser-Beschichten (laser ablation deposition), die verfahrensimmanent einen hohen Ionisierungsgrad und damit eine wirkungsvolle Steuerbarkeit des Kondensationsprozesses durch ionengestützte Prozessführung ermöglichen. Beim Magnetron-Sputtern ist dagegen der Ionisierungsgrad und damit das Potential zur Verbesserung von Schichteigenschaften begrenzt. Die Begründung liegt im Mechanismus der Magnetron-Entladung selbst, der eine hohe Plasmadichte in unmittelbarer Nähe der Katode, d. h. des Targets, durch ein speziell geformtes Magnetfeld beinhaltet. Die Ladungsträgerdichte im Bereich des zu beschichtenden Substrates ist dagegen größenordnungsmäßig geringer und liegt maximal im Prozentbereich, bezogen auf die Ladungsträgerdichte vor der Kathode. Es ist meist nicht möglich, angestrebte Verbesserungen der Schichteigenschaften bei zu geringer Plasmadichte im Bereich des Substrates dadurch zu erreichen, dass die Vorspannung am Substrat gegenüber dem Plasmapotential vergrößert wird. Die höhere Teilchenenergie führt zu veränderten Elementarprozessen während des Kondensationsprozesses, z. B. zur Besetzung von Zwischengitterplätzen, massiven Strukturdefekten oder Änderung der Schichtzusammensetzung im Falle von Schichten aus chemischen Verbindungen.

Es sind deshalb unterschiedliche Methoden und Einrichtungen zum Zerstäuben vorgeschlagen worden, um eine Verbesserung des plasmaaktivierten Sputterns zu erreichen. Es sind Einrichtungen bekannt, die das Prinzip des Magnetron-Sputterns verlassen und durch andere Gestaltungen von Magnetfeldern ersetzen (US 6,423,191).
Es ist weiterhin bekannt, für Zerstäubungseinrichtungen entsprechend dem Magnetron-Prinzip zusätzliche magnetfelderzeugende Spulen oder Permanentmagnete zu verwenden, die ein Magnetfeld erzeugen, welches dem Magnetron-Magnetfeld überlagert wird und Feldlinien in Richtung der Verbindungslinie vom Target zum Substrat aufweist. Aus der großen Zahl derartiger Anordnungen seien beispielhaft Wang [J. Wang, Y.-H. Yu, S. C. Lee, Y.-W. Chung: Tribological and optical properties of crystalline and amorphous alumina thin films grown by low-temperature reactive magnetron sputtering, Surf. Coat. Technol. 146-147 (2001) 189-194] und Mayrhofer [P. H. Mayrhofer, F. Kunc, J. Musil, C. Mitterer: A comparative study on reactive and non-reactive unbalanced magnetron sputter deposition of TiN coatings, Thin Solid Films, 415 (2002) 151-159] genannt. Die Zusatz-Magnetfelder haben die Form eines Helmholtz-Feldes oder wirken als Solenoid-Spulen in Substratnähe und gegebenenfalls zusätzlich im Bereich des Targets.

Andere Anordnungen von Magnetpolen oder Spulen sollen auf der gesamten Wand des Rezipienten eine Region höherer Plasmadichte erzeugen. Beispielhaft hierfür sind sog. Closed-field-Anordnungen [D. G. Teer: A Magnetron Sputter Ion Plating System, Surf. Coat. Technol. 36 (1988) 901-907]. Trotz eines teilweise hohen apparativen Aufwandes sind die erreichbaren Werte für die Plasmadichte in Substratnähe und somit der extrahierbare Ladungsträgerstrom am Substrat auf wenige Prozent des Entladungsstromes begrenzt. Neben Einrichtungen zum Magnetron-Zerstäuben mit zusätzlichen Elektromagneten, die eine erhöhte Plasmaaktivierung bewirken sollen, sind zahlreiche Einrichtungen vorgeschlagen worden, bei denen Elektromagneten dazu dienen, die Lage des Bereiches hoher Plasmadichte auf dem Target zu beeinflussen, um die Target-Erosion und damit die Target-Ausnutzung und/oder die Schichtdickenverteilung auf großflächigen Substraten günstig zu beeinflussen oder um das Abscheiden von Legierungs- und/oder Verbindungsschichten aus mehreren Komponenten, das sog. "co-sputtering" zu steuern. Solche Einrichtungen sind z. B. in DD 200 804; DE 37 27 901 A1; DE 39 08 252 A1; JP 61183375; US 4,401,539 und US 4,865,712 beschrieben.
Eine Einrichtung zum Sputtern, die eine Erhöhung der Ladungsträgerdichte im substratnahen Bereich erlaubt, ist das sog. "unbalanced magnetron". [B. Window, N. Savvides: Unbalanced dc magnetrons as sources of high ion fluxes, J. Vac. Sci. Technol. A 4 (1986) 3, S. 453-456] [W.D. Münz: The unbalanced magnetron. Current state and development, Surf. Coat. Technol. 48 (1991) 81-94]. Durch Veränderung der Polstärken von Innenpolen und Außenpolen der Magnetron-Magneteinrichtungen wird versucht, einen Teil der Magnetfeldlinien aus dem targetnahen in den substratnahen Bereich zu verlagern. Da energiereiche Elektronen aus dem Ring-Elektronenstrom der Magnetron-Entladung mit ihrer Gyrationsbewegung den Magnetfeldlinien folgen, kann die Plasmadichte in Substratnähe gegenüber den Verhältnissen in einem "balanced magnetron" erhöht werden. Die Wirkung ist jedoch umso schwieriger erreichbar, je größer der Abstand zwischen Target und Substrat ist und je ausgedehnter das zu beschichtende Substrat ist. Insbesondere ist es technisch nicht möglich, eine homogene Verteilung des Ladungsträgerstromes zum Substrat zu erreichen. Durch den Ladungsträgerverlust im Ring-Elektronenstrom am Target erhöht sich außerdem die Impedanz der Magnetron-Entladung. Im Extremfall hochgradig unbalancierter Einrichtungen kann sich die Magnetron-Entladung gar nicht mehr ausbilden. Um seinen Ionisierungsgrad zu erhöhen, kann dem Plasma auch induktiv eingekoppelte Energie zugeführt werden. Dazu dienen z. B. Induktionsspulen außerhalb des Rezipienten oder im Inneren des Rezipienten im Bereich der Wandungen und HochfrequenzGeneratoren mit den erforderlichen Anpass-Netzwerken. Auch solche Einrichtungen, wie sie z. B. in US 6,187,151 und US 6,350,353 vorgeschlagen werden, sind technisch aufwändig und stellen für größere Substratausdehnungen und hohe Leistungen eine erhebliche Komplizierung und Verteuerung der Zerstäubungseinrichtung dar.

Die gepulste Einspeisung der Energie in eine Magnetron-Entladung (DD 252 205;
DE 37 00 633 C1) mit einer Pulsfrequenz im Bereich von 10 bis 200 kHz, die an sich zur Verhinderung des Umschlagens der Magnetron-Entladung in eine Bogenentladung bei der reaktiven Abscheidung von Verbindungsschichten eingeführt worden ist, ist ebenfalls mit einer Erhöhung des Ladungsträgerbombardements und der Aktivierung des Kondensationsprozesses der aufwachsenden Schicht verbunden.

Besonders beim Puls-Magnetron-Sputtern mit einer Doppelanordnung von zwei Magnetronquellen oder zwei Gruppen von Magnetronquellen und Einspeisung eines Wechselstromes, bei dem die Magnetron-Quellen periodisch als Anode und Katode einer Magnetron-Entladung wirken, findet eine deutliche Erhöhung der mittleren Energie der kondensierenden Teilchen statt. Die Ursache wird in der mit der Pulsfrequenz periodisch vorgenommenen Fortschaltung des elektrischen Feldes gesehen, wodurch es zu einer erhöhten Diffusion energiereicher Ionen in diesen Phasen der bipolar gepulsten Magnetron-Entladung kommt und ein Teil der höherenergetischen Spezies das Substrat erreichen kann. Ähnlich wie in Einrichtungen zum "unbalanced magnetron sputtering" bestimmen jedoch auch hier Form und Stärke des Magnetron-Magnetfeldes im Bereich der Elektroden den Grad der erreichbaren Plasmaaktivierung und die lokale Verteilung der Plasmadichte im Bereich des Substrates. Eine homogene Verteilung der Ladungsträgerdichte und damit der Schichteigenschaften auf dem Substrat lässt sich umso schwerer erzielen, je größer das Substrat ist. Auch eine Anordnung zum Puls-Magnetron-Sputtern mit weit voneinander entfernten Magnetronquellen, die paarweise betrieben werden (DE 198 60 474 A1) führt nur zu einer quantitativen Verbesserung, aber nicht generell zur Überwindung der Nachteile.

Es ist deshalb Aufgabe der Erfindung, ein verbessertes Verfahren und eine verbesserte Einrichtung zum plasmaaktivierten Magnetron-Sputtern anzugeben. Insbesondere ist eine höhere Aktivierung der schichtbildenden Teilchen durch das Plasma der Magnetron-Sputtereinrichtung gefordert, als sie nach dem Stand der Technik erreicht wird. Der Grad der Plasmaaktivierung soll sich entsprechend den angestrebten Schichteigenschaften steuern lassen. Im Fall einer reaktiven Schichtabscheidung soll eine hohe Reaktivität der chemischen Reaktionspartner gesichert werden. Die Einrichtung soll sichern, dass die Plasmaaktivierung homogen ist und dadurch eine Schicht mit vorteilhaften und homogenen Eigenschaften auf dem Substrat abgeschieden werden kann. Die Einrichtung soll geeignet sein, die plasmaaktivierte Abscheidung auch auf solchen Substraten zu ermöglichen, die elektrisch isolierend sind und sich nicht elektrisch kontaktieren lassen. Es ist eine einfache und dadurch kostengünstige Einrichtung angestrebt.

Die Aufgabe wird durch ein Verfahren gemäß Anspruch 1 gelöst. Weitere vorteilhafte Ausgestaltungen des erfindungsgemäßen Verfahrens sind in den Ansprüchen 2 bis 12 beschrieben. Anspruch 13 gibt eine Einrichtung zur Durchführung des erfindungsgemäßen Verfahrens an. Die Ansprüche 14 bis 24 beschreiben vorteilhafte Ausführungsformen derartiger Einrichtungen.

Ausgehend von an sich bekannten Kathodenzerstäubungsverfahren nach dem Magnetron-Prinzip, bei denen nahe an den Targets eine hohe Elektronendichte erzeugt wird, die durch die typische Gestaltung des Magnetfeldes auch im targetnahen Bereich gehalten wird, beruht das erfindungsgemäße Verfahren auf einem Magnetfeld, dessen Feldstärke variabel ist. Es kann so eingestellt werden, dass sich die Elektronen nahezu vollständig auf Zykloidenbahnen im Bereich magnetischer Tunnel dicht über den zu zerstäubenden Targetflächen bewegen. Es kann jedoch auch so eingestellt werden, dass nur ein Teil der während der Energieeinspeisung in das Zerstäubungsplasma entstehenden Elektronen auf derartigen Bahnen geführt wird und ein Teil durch das für Kathodenzerstäubungsverfahren unumgängliche elektrische Feld zwischen Anode und Kathode bei entsprechender Anordnung der Anode in Substratrichtung beschleunigt wird. Als vorteilhaft hat sich eine gezielte Reduzierung des Absolutbetrages der magnetischen Feldstärke auf einen solchen Wert erwiesen, der eine Verringerung des Entladungsstromes der Magnetronentladung um mindestens 20 %, besonders vorteilhaft um mindestens 50 %, bewirkt. Das zur Aufrechterhaltung des Magnetron-Prinzips erforderliche Magnetfeld kann erfindungsgemäß auch für kurze Zeit ganz weggeschaltet werden, was bedeutet, dass alle ansonsten in der "Magnetfalle" befindlichen Elektronen in Richtung Substrat oder Anode beschleunigt werden. Erfindungsgemäß wird während der Beschichtung die Stärke des Magnetfeldes mehrfach, vorzugsweise periodisch, geändert. Als vorteilhaft haben sich Absenkungen der magnetischen Feldstärke für eine Dauer von weniger als 10 Millisekunden, vorzugsweise weniger als eine Millisekunde erwiesen. Bei einer periodischen Absenkung haben sich Frequenzen von mindestens 50 Hz, besser noch von mindestens 500 Hz, bewährt. Dadurch umfasst das Verfahren Zeitabschnitte, in denen bei einer hohen Elektronendichte in Targetnähe eine effektive Abstäubung von Targetmaterial erfolgt und Zeitabschnitte, in denen bei verringerter Zerstäubungsrate vor allem eine effektive Ionisierung durch beschleunigte Elektronen im gesamten Entladungsraum erfolgt. Der Grad der Verringerung der magnetischen Feldstärke erlaubt daneben eine einfache Einstellung des Grades der Plasmaaktivierung. Auf diese Weise kann auch über große Bereiche eine hohe Gleichmäßigkeit der Aktivierung in Substratnähe und damit eine hohe Gleichmäßigkeit verschiedener Schichteigenschaften erzielt werden. Ein hoher Grad der Plasmaaktivierung sorgt außerdem bei Bedarf für eine hohe Reaktivität der Reaktionspartner bei reaktiven Beschichtungsprozessen. Besonders vorteilhaft ist es, das periodisch oder aperiodisch variierte Magnetfeld mit einer gepulsten Energieeinspeisung in das Plasma zu kombinieren. In diesem Fall lässt sich das erfindungsgemäße Verfahren auch für die Beschichtung nicht kontaktierbarer elektrisch isolierender Substrate einsetzen. Das Verfahren kann dabei vorteilhafterweise derart durchgeführt werden, dass die zeitlichen Verläufe der Magnetfelderregung und der gepulsten Energieeinspeisung in die Gasentladung synchronisiert sind.

Erfindungsgemäß ist eine Einrichtung zum Magnetron-Sputtern mit einer magnetfelderzeugenden Einheit ausgestattet, die zumindest elektromagnetische Mittel umfasst, die eine mehrfache, zweckmäßigerweise eine periodische Verringerung des Absolutwertes der magnetischen Feldstärke auf elektromagnetischem Wege erlaubt. Unter der Voraussetzung, dass nicht gleichzeitig andere Betriebsparameter der Magnetron-Entladung drastisch verändert werden, wird bei jeder deutlichen Reduzierung des Absolutbetrages des Magnetron-Magnetfeldes bzw. einem Fortschalten des Magnetron-Magnetfeldes eine große Zahl von energiereichen Elektronen aus dem Ringstrom im katodennahen Bereich frei, die zuvor in dem allgemein als "Magnetfalle für die Elektronen" bezeichneten Bereich auf Zykloidenbahnen geführt worden sind. Anders als im Fall der gepulsten Energieeinspeisung in die Magnetron-Entladung, bei der das elektrische Feld zeitweise Null wird, ist die erfindungsgemäße Einrichtung dadurch gekennzeichnet, dass die magnetische Führung der Elektronen zeitweise vollständig oder teilweise aufgehoben ist. Unter der Wirkung des weiterhin wirksamen elektrischen Feldes erfolgt bei schwacher oder fehlender magnetischer Führung eine intensive Ionisierung durch Stöße energiereicher freier Elektronen im gesamten Entladungsraum. Anschließend wird die Magnetfeldstärke des Magnetron-Magnetfeldes wieder auf den ursprünglichen oder zumindest einen höheren Betrag gebracht. Dabei erhöht sich mit hoher Stromanstiegsgeschwindigkeit der Entladungsstrom, wobei sich die Zahl der Elektronen, die den Magnetron-Ringstrom bilden, ebenfalls entsprechend erhöht. Im Zustand der starken magnetischen Führung erfolgt somit eine Anreicherung der kathodennahen Bereiche des Entladungsraumes mit Elektronen, die in Phasen geringer oder fehlender magnetischer Führung in den gesamten Entladungsraum, also auch bis in Substratnähe entlassen werden. Erfindungsgemäß wird häufig zwischen diesen beiden Zuständen gewechselt. Damit lässt sich der Ionisierungsgrad im Zeitmittel auch in Substratnähe auf einen hohen Betrag anheben und dem Betrage nach steuern. Außerdem ist auch die Wirkung energiereicher Spezies auf dem Substrat weitgehend homogen.

Zweckmäßigerweise sind die Mittel der magnetfelderzeugenden Einheit, die die zeitweilige Reduzierung der Magnetfeldstärke bewirken, so gestaltet, dass die Reduzierung der Feldstärke jeweils für eine Dauer von weniger als 10 Millisekunden erfolgt, vorzugsweise sogar für eine Dauer von weniger als einer Millisekunde. Die Mittel sind außerdem so gestaltet, dass die Reduzierung mit einer Häufigkeit von mindestens 50 Mal je Sekunde, vorzugsweise sogar von mindestens 500 Mal je Sekunde erfolgen kann. Deshalb werden bevorzugt Spulen zur anteiligen oder vollständigen Erzeugung des Magnetron-Magnetfeldes eingesetzt, die eine möglichst geringe Induktivität aufweisen, also aus wenigen Windungen für hohe Spulenströme aufgebaut sind.

Für eine Quantifizierung des erfindungsgemäßen Effektes eignet sich besonders eine Überwachung des Entladungsstromes der Magnetron-Entladung. Es hat sich gezeigt, dass bereits mit Einrichtungen, in denen lediglich eine zeitweise Reduzierung des Absolutbetrages der magnetischen Feldstärke auf einen solchen Wert erfolgt, der eine Verringerung des Entladungsstromes der Magnetronentladung um 20 % bewirkt, hervorragende Beschichtungsresultate erzielt werden können. Eine weitere Reduzierung der magnetischen Feldstärke ist vorteilhaft. So haben sich Einrichtungen als besonders effektiv erwiesen, bei denen die zeitweise Reduzierung des Absolutbetrages der magnetischen Feldstärke auf solche Werte erfolgt, die eine Verringerung des Entladungsstromes der Magnetronentladung um mindestens 50 % bewirken. Eine besonders einfache Einrichtung ist mit einer Vielzahl von Permanentmagneten in einer Anordnung, wie sie für bekannte Magnetron-Sputterquellen üblich ist, und einer Vorrichtung zur elektromagnetischen Erzeugung eines zeitabhängigen Feldes ausgestattet, wobei sich das durch die Permanentmagneten erzeugte Magnetfeld und das elektromagnetisch erzeugte Magnetfeld so überlagern, dass die Gesamtfeldstärke je nach der Stromrichtung im elektromagnetischen Teil hohe bzw. niedrige Werte annehmen kann. Die Erregung der Magnetspulen erfolgt dafür im einfachsten Fall sinusförmig.
Eine sehr leistungsfähige erfindungsgemäße Einrichtung umfasst außer gegebenenfalls einer permanentmagnetischen Magnetanordnung mindestens zwei Magnetspulen angepasster Geometrie, die durch pulsförmige Gleichströme erregt werden können, welche sich nach einem vorgebbaren Zeitregime programmiert steuern lassen.

Es ist weiterhin vorteilhaft, die Einrichtung so zu gestalten, dass eine zeitweilige vollständige Aufhebung des Magnetron-Magnetfeldes möglich ist oder dass die Richtung des Magnetron-Magnetfeldes sogar umgepolt werden kann. Das trifft vor allem für Einrichtungen zum Magnetron-Sputtern zu, deren Magnetfeld ausschließlich elektromagnetisch erzeugt wird.

Die erfindungsgemäße Sputtereinrichtung zur plasmaaktivierten Beschichtung kann vorteilhafterweise auch durch eine mittelfrequent mit 10 bis 200 kHz gepulste Energiezufuhr für die Magnetron-Entladung betrieben werden. Dadurch werden die Vorteile einer gepulsten Magnetronentladung mit den Vorteilen der erfindungsgemäßen zeitweisen Erhöhung der Ladungsträgerdichte im substratnahen Bereich kombiniert. Diese Einrichtung mit einer Kombination von gepulster Entladungsspannung und zeitweiser, z. B. periodisch mit geringerer Frequenz gepulster Reduzierung der Stärke des Magnetron-Magnetfeldes lässt sich vor allem bei der reaktiven Abscheidung elektrisch isolierender Schichten aus einer chemischen Verbindung mit Vorteil zur Anwendung bringen. Sie sichert zum einen eine stabile Prozessführung ohne elektrische Überschläge und zum anderen eine steuerbare und intensive Plasmaaktivierung des Kondensationsprozesses. Besonders vorteilhaft ist es, die Einrichtung gemäß der Erfindung weiterhin derart auszustatten, dass die Mittel zur zeitweiligen Reduzierung der Energieversorgung der magnetfelderzeugenden Einrichtung und die Energieversorgung der Gasentladung eine Synchronisation beider Energieflüsse ermöglichen. Die Reduzierung der magnetischen Feldstärke und die Energieeinspeisung können dabei in einer Weise periodisch gepulst erfolgen, dass die zeitlichen Verläufe für beide Kenngrößen synchronisiert sind. Vorteilhafterweise enthält die erfindungsgemäße Einrichtung Mittel zur Speisung der magnetfelderzeugenden Spulen und zusätzliche Mittel zur Einspeisung der Energie in Form mittelfrequent gepulster Energie in das Plasma, die eine Synchronisation die hierzu erforderlichen Spannungen bzw. Ströme ermöglichen. Die Pulsfrequenzen können dabei identisch sein oder sich um einen konstanten oder einstellbaren Faktor unterscheiden.

Wie allgemein für die ionengestützte oder plasmagestützte Beschichtung bekannt ist, kann die Aktivierung des Kondensationsprozesses durch Anlegen einer Vorspannung am Substrat ("Bias") beeinflusst und verändert werden, da sich dadurch die Energie der geladenen Spezies des Plasmas, z. B. der Ionen, verändern lässt. Das gilt auch für die erfindungsgemäße Einrichtung, die gegebenenfalls auch Mittel zur Kontaktierung des Substrates und zum Anlegen einer Vorspannung einstellbarer Größe umfasst. Das ermöglicht neben der Einstellung der Ladungsträgerdichte in Substratnähe gleichzeitig die Beeinflussung der Energie auftreffender Plasmaspezies. Die erfindungsgemäße Einrichtung ist dadurch besonders vielseitig und gut an unterschiedliche Prozesserfordernisse anzupassen.

An dieser Stelle soll jedoch darauf hingewiesen werden, dass die erfindungsgemäße Einrichtung vorzugsweise auch eine viel vorteilhaftere Form der plasmagestützten Beschichtung ermöglicht, bei der die Energie der Ionen aus dem Plasma durch sogenanntes "self biasing", also eine Potentialdifferenz zwischen Substrat und Plasmapotential, eingestellt werden kann. Der mit der erfindungsgemäßen Einrichtung erreichbare höhere Ionisierungsgrad begünstigt diese Art der Steuerung und ist ohne Kontaktierung der Substrate, also bevorzugt für elektrisch isolierende Substrate praktikabel.

An einem Ausführungsbeispiel wird die Erfindung näher erläutert. Die zugehörigen Zeichnungen illustrieren die Wirkungsweise einer erfindungsgemäßen Einrichtung.
Im Einzelnen zeigt
- Fig. 1a: das Wirkschema einer erfindungsgemäßen Einrichtung im Zustand des maximalen Betrages der Magnetron-Magnetfeldstärke,
- Fig. 1b: ein korrespondierendes Wirkschema im Zustand des minimalen Betrages der Magnetron-Magnetfeldstärke,
- Fig. 2a-d: den zeitlichen Verlauf von Spulenstrom, Betrag der resultierenden Magnetfeldstärke, Entladungsstrom der Magnetron-Entladung und Ionenstrom zum Substrat beim Betrieb einer erfindungsgemäßen Einrichtung und
- Fig. 3: die relative Erhöhung des Anteils ionisierter Teilchen zum Substrat mit steigender Häufigkeit der Reduzierung der Magnetfeldstärke.

Eine beispielhafte Einrichtung zum plasmaaktivierten Magnetron-Sputtern umfasst neben einem zu beschichtenden Substrat (1) das zu zerstäubende Material in Form eines Targets (2), eine an sich bekannte Vorrichtung zur Erzeugung eines Magnetron-Magnetfeldes, die aus Permanentmagneten, welche einen Außenpol (3) bilden, aus Permanentmagneten, welche einen Innenpol (4) bilden, einem weichmagnetischen Joch (5) und elektromagnetisch erregbaren Spulen (6) gebildet wird. Als Anode (7) dient ein Teil der Wand des Vakuumbehälters, in dem die gesamte Einrichtung untergebracht ist. Eine Stromversorgungseinheit (8) und eine Steuereinheit (9) ergänzen die Vorrichtung zur Magnetfelderzeugung. Die durch die Permanentmagneten und die durch die Elektromagneten erzeugten Magnetfelder überlagern sich derart, dass ein resultierendes Magnetron-Magnetfeld (10) entsteht, dessen Feldlinien in der Target-Ebene austreten und wieder eintreten und die insgesamt einen tunnelförmigen, in sich ringförmig geschlossenen Bereich bilden, in dem eine Tangentialkomponente des Magnetfeldes, gemessen parallel zur Targetoberfläche und in Höhe der dem Substrat zugewandten Fläche, von 20 kA m⁻¹ einstellbar ist. Erfindungsgemäß ist die Einrichtung mit Mitteln ausgestattet, die eine zeitweise Absenkung des Betrages der Magnetfeldstärke auf sehr kleine Werte oder Null erlaubt. Diese Mittel sind im Ausführungsbeispiel in einer pulsweitenmodulierten Spannungsquelle (11) mit einer Ausgangsspannung von 500 V für die Spulenströme vereint. Zwischen dem als Katode geschalteten Target und der Anode wird ein elektrisches Feld (12) erzeugt und eine Magnetron-Entladung etabliert.

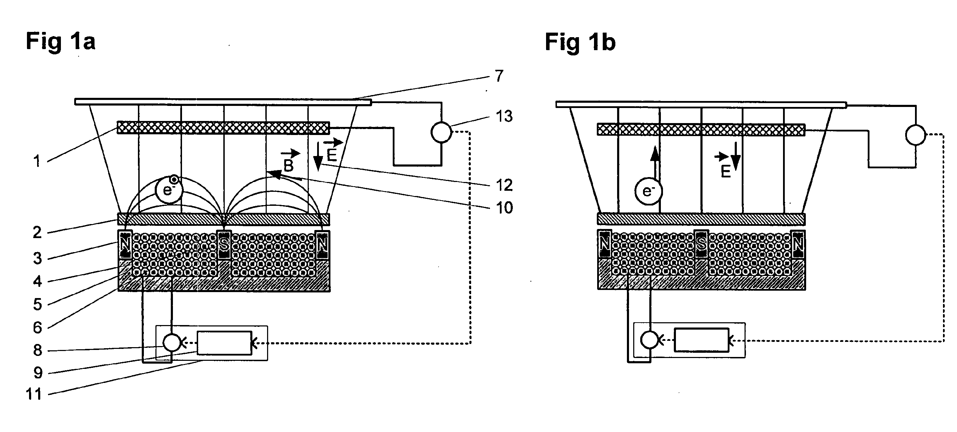

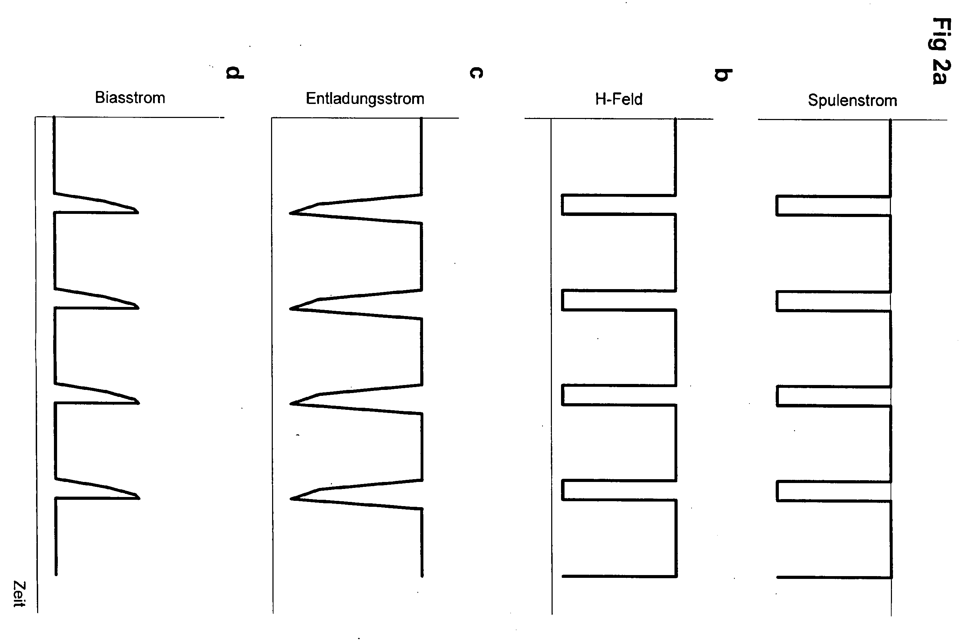

Die Mittel zur zeitweiligen Reduzierung des Absolutwertes der Magnetfeldstärke wirken dahingehend, dass sich das elektromagnetisch erzeugte und das durch die Permanentmagneten erzeugte Magnetfeld während der Reduzierung der magnetischen Feldstärke weitgehend kompensieren. Die resultierende Magnetfeldkomponente wird von 20 kA m⁻¹ auf 2 kA m⁻¹ reduziert. Wird die Magnetron-Entladung mit einer Spannung von 500 V zwischen Target und Anode betrieben, so bewirkt die Erregung der Spulen eine Änderung des Entladungsstromes von 20 A auf 2,5 A. Die Zone hoher Plasmadichte auf dem Target verbreitert sich sehr stark. Das Target ist mit einem quasi homogenen Plasma bedeckt. Dieser Zustand ist in Fig. 1b veranschaulicht. Die Auswirkungen der Reduzierung des Betrages des Magnetron-Magnetfeldes sind in Fig. 2 schematisch erkennbar. Die Folge der Reduzierung des Magnetfeldes (Fig. 2b) sind die genannte Reduzierung des Momentanwertes des Entladungsstromes (Fig. 2c) und ein sprunghafter Anstieg des Ionenstromes zum Substrat ("Biasstrom", Fig. 2d), der unter der Wirkung einer Biasstromversorgung (13) gemessen werden kann. Die Schalteinrichtung für die Spulenströme ist so ausgeführt, dass die Dauer der Reduzierung des Magnetron-Magnetfeldes einheitlich jeweils 0,5 Millisekunden beträgt. Die Häufigkeit dieser Schalthandlungen lässt sich im Beispiel auf den Bereich von 10 bis 1000 je Sekunde einstellen. Vorteilhafterweise wird der Mittelwert des Biasstromes zum Substrat gemessen und als Istwert für die Regelung der Häufigkeit der Reduzierung der Magnetron-Magnetfeldstärke genutzt.

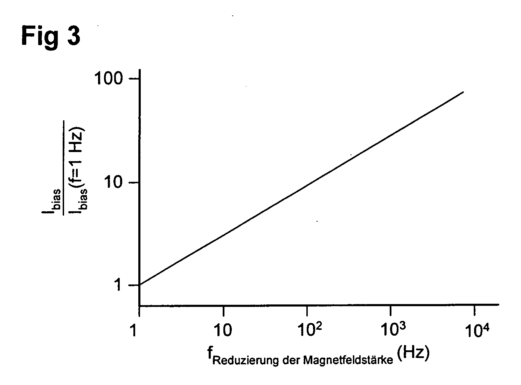

Der Zusammenhang zwischen der Häufigkeit der Reduzierung der Magnetron-Magnetfeldstärke und dem zeitlichen Mittelwert des Biasstromes, der für die beispielhafte Einrichtung gemessen werden kann, ist in Fig. 3 dargestellt. Es ist erkennbar, dass sich der Grad der Plasmaaktivierung größenordnungsmäßig erhöhen lässt, wenn die erfindungsgemäßen Mittel genutzt werden.
Als Maß für den erreichten Grad der Plasmaaktivierung dient der über das Substrat abgeleitete Biasstrom.

Es kann somit ein vorgegebener Grad der Plasmaaktivierung eingestellt und über den Biasstrom überwacht werden. Der Biasstrom wird über die Häufigkeit der Reduzierung der magnetischen Feldstärke direkt eingestellt. Sinkt der Biasstrom unter einen Sollwert, wird die Häufigkeit der Feldstärkereduzierungen erhöht, bis der Sollwert wieder erreicht ist, was eine einfache Regelung ermöglicht. Auf diese Weise lässt sich eine Plasmaaktivierung hoher Gleichmäßigkeit erzielen.

## Patentansprüche

1. Verfahren zur plasmaaktivierten Schichtabscheidung durch Kathodenzerstäubung nach dem Magnetron-Prinzip, **dadurch gekennzeichnet, dass** während der Beschichtung mehrmals eine gezielte Reduzierung des Absolutbetrages der magnetischen Feldstärke des Magnetron-Magnetfeldes auf einen solchen Wert vorgenommen wird, der eine Verringerung des Entladungsstromes der Magnetronentladung um mindestens 20 % bewirkt.

2. Verfahren nach Anspruch 1, **dadurch gekennzeichnet, dass** während der Beschichtung mehrmals eine gezielte Reduzierung des Absolutbetrages der magnetischen Feldstärke des Magnetron-Magnetfeldes auf einen solchen Wert vorgenommen wird, der eine Verringerung des Entladungsstromes der Magnetronentladung um mindestens 50 % bewirkt.

3. Verfahren nach Anspruch 1 oder 2, **dadurch gekennzeichnet, dass** die Reduzierung der magnetischen Feldstärke periodisch erfolgt.

4. Verfahren nach Anspruch 3, **dadurch gekennzeichnet, dass** die Reduzierung der magnetischen Feldstärke durch sinusförmige Erregung elektromagnetischer Mittel zur Magnetfelderzeugung erfolgt.

5. Verfahren nach Anspruch 3, **dadurch gekennzeichnet, dass** die Reduzierung der magnetischen Feldstärke durch zyklisches Umschalten zwischen zwei Erregungszuständen elektromagnetischer Mittel zur Magnetfelderzeugung erfolgt.

6. Verfahren nach Anspruch 4 oder 5, **dadurch gekennzeichnet, dass** die Absenkung der magnetischen Feldstärke mit einer Frequenz von mindestens 50 Hz erfolgt.

7. Verfahren nach Anspruch 4 oder 5, **dadurch gekennzeichnet, dass** die Absenkung der magnetischen Feldstärke mit einer Frequenz von mindestens 500 Hz erfolgt.

8. Verfahren nach einem der Ansprüche 1 bis 7, **dadurch gekennzeichnet, dass** die Energieeinspeisung unipolar oder bipolar gepulst mit einer Frequenz von 10 bis 200 kHz erfolgt.

9. Verfahren nach mindestens einem der Ansprüche 1 bis 8, **dadurch gekennzeichnet, dass** die Reduzierung der magnetischen Feldstärke und die Energieeinspeisung periodisch gepulst erfolgen und die zeitlichen Verläufe für beide Kenngrößen synchronisiert sind.

10. Verfahren nach einem der Ansprüche 1 bis 9, **dadurch gekennzeichnet, dass** das Substrat mit einer Vorspannung beaufschlagt wird.

11. Verfahren nach Anspruch 10, **dadurch gekennzeichnet, dass** der über das Substrat abfließende Biasstrom durch die Häufigkeit der Reduzierung der magnetischen Feldstärke eingestellt wird.

12. Verfahren nach Anspruch 11, **dadurch gekennzeichnet, dass** der über das Substrat abfließende Biasstrom durch die Häufigkeit der Reduzierung der magnetischen Feldstärke geregelt eingestellt wird.

13. Einrichtung zur plasmaaktivierten Schichtabscheidung durch Kathodenzerstäubung nach dem Magnetron-Prinzip mit einer magnetfelderzeugenden Einheit zur Erzeugung des Magnetron-Magnetfeldes, die elektromagnetische Mittel zur Erzeugung eines Magnetfeldes enthält, **dadurch gekennzeichnet, dass** die magnetfelderzeugende Einheit mit Mitteln zur gezielten Reduzierung des Absolutbetrages der magnetischen Feldstärke des Magnetron-Magnetfeldes auf einen solchen Wert ausgestattet ist, der eine Verringerung des Entladungsstromes der Magnetronentladung um mindestens 20 % bewirkt.

14. Einrichtung nach Anspruch 13, **dadurch gekennzeichnet, dass** Mittel zur periodischen Reduzierung der magnetischen Feldstärke enthalten sind.

15. Einrichtung nach Anspruch 13 oder 14, **dadurch gekennzeichnet, dass** die magnetfelderzeugende Einheit mit Mitteln zur Reduzierung des Absolutbetrages der magnetischen Feldstärke auf einen solchen Wert ausgestattet ist, der eine Verringerung des Entladungsstromes der Magnetronentladung um mindestens 50 % bewirkt.

16. Einrichtung nach einem der Ansprüche 13 bis 15, **dadurch gekennzeichnet, dass** besagte Mittel die Reduzierung der Feldstärke für eine Dauer von weniger als 10 Millisekunden und die Häufigkeit der Reduzierung der Feldstärke von mindestens 50 Mal je Sekunde ermöglichen.

17. Einrichtung nach Anspruch 16, **dadurch gekennzeichnet, dass** besagte Mittel die Reduzierung der Feldstärke für eine Dauer von weniger als einer Millisekunde und die Häufigkeit der Reduzierung der Feldstärke von mindestens 500 Mal je Sekunde ermöglichen.

18. Einrichtung nach einem der Ansprüche 13 bis 17, **dadurch gekennzeichnet, dass** die Mittel eine zeitweilige vollständige Aufhebung des Magnetfeldes erlauben.

19. Einrichtung nach einem der Ansprüche 13 bis 18, **dadurch gekennzeichnet, dass** die Mittel eine Umpolung der Richtung des Magnetfeldes erlauben.

20. Einrichtung nach einem der Ansprüche 13 bis 19, **dadurch gekennzeichnet, dass** die magnetfelderzeugende Einheit eine Anordnung von Permanentmagneten und mindestens einer magnetfelderzeugenden Spule umfasst, welche durch einen sinusförmigen Wechselstrom erregt wird.

21. Einrichtung nach einem der Ansprüche 13 bis 19, **dadurch gekennzeichnet, dass** die magnetfelderzeugende Einheit eine Anordnung von Permanentmagneten und mindestens zwei magnetfelderzeugenden Spulen umfasst, welche durch pulsförmige Gleichströme erregt werden, wobei letztere nach einem vorgegebenen Zeitregime gesteuert werden.

22. Einrichtung nach einem der Ansprüche 13 bis 21, **dadurch gekennzeichnet, dass** zusätzlich Mittel zur Einspeisung einer mit einer Frequenz im Bereich von 10 bis 200 kHz unipolar oder bipolar gepulsten Spannung zum Betreiben der Magnetron-Entladung vorhanden sind.

23. Einrichtung nach mindestens einem der Ansprüche 13 bis 22, **dadurch gekennzeichnet, dass** die Mittel zur Speisung der magnetfelderzeugenden Spulen und die zusätzlichen Mittel zur Einspeisung der Energie in Form mittelfrequent gepulster Energie eine Synchronisation beider Spannungen bzw. Ströme ermöglichen.

24. Einrichtung nach einem der Ansprüche 13 bis 23, **dadurch gekennzeichnet, dass** zusätzlich Mittel zum Anlegen einer elektrischen Vorspannung an das Substrat vorhanden sind.
